# EUROPEAN PATENT APPLICATION

(11) **EP 1 965 425 A1**
(43) Date of publication of application: **03.09.2008**
(21) Application number: 07004266.8
(22) Date of filing: 01.03.2007
(51) Int. Cl.: H01L 27/02

(54) **Reverse voltage protected integrated circuit arrangement**

(71) Applicant: Infineon Technologies Austria AG, 9500 Villach (AT)
(72) Inventor: Pastorina, Salvatore, 95123 Catania (IT); Logiudice, Andrea, 35136 Padova (IT); Scenini, Andrea, 35031 Abano Terme (Pd) (IT); Wotruba, Bernhard, 35132 Padova (IT)
(74) Representative: Bickel, Michael

(57) **Abstract**

An integrated circuit arrangement comprising a semiconductor body (1, 2) having a substrate (1) and at least one substrate terminal (B₁, B₂), at least one semiconductor component (M₁, M₂) integrated in said semiconductor body (1, 2) and being connected between a first supply terminal providing a first supply potential (V_{DD}) and a second supply terminal providing a second supply potential (V_{SS}), and switching means adapted for connecting at least one of said substrate terminals (B₁, B₂) to either said first or to said second supply terminal (V_{DD}, V_{SS}) dependent on which supply terminal provides the lower supply potential.

## Description

The present invention relates to an integrated circuit arrangement for protecting a semiconductor device during reverse voltage operation.

In many applications semiconductor devices have to be equipped with a reverse voltage protection. In unprotected devices the supply voltage can be shorted by the substrate diode of the semiconductor chip. XConsidering a MOSFET as an example, a substrate diode can be formed by the pn-junction between a p-doped substrate and an n-doped drain zone located adjacent to the substrate in an epitaxial layer which has been deposited onto the substrate. In order to inhibit such short circuits, the substrate can be isolated during reverse voltage operation. As a consequence the potential of the substrate is floating and undefined, i.e. the potential of the substrate depends on the state of other components integrated in the same substrate. A floating substrate entails the risk of a latch-up of parasitic thyrisor structures inherent in many integrated circuits.

It is an object of the invention, to provide a integrated circuit arrangement which is capable of withstanding a certain reverse voltage without the risk of a high current flow and a latch-up due to parasitic semiconductor structures.

This object is achieved by an integrated circuit arrangement as recited in claim 1. Various embodiments are covered by the dependent claims.

One embodiment of the invention relates to an integrated circuit arrangement comprising a semiconductor body having a substrate and at least one substrate terminal. Via the at least one substrate terminal the semiconductor substrate can be supplied with any external potential. The integrated circuit arrangement further comprises at least one semiconductor component integrated in the semiconductor body. The semiconductor component may be a semiconductor switch and may be connected between a first and a second supply terminal providing a first and a second supply potential respectively. In order to provide for an adequate reverse voltage protection the integrated circuit arrangement additionally comprises switching means adapted for connecting the at least one substrate terminal to one of said first and second supply terminal dependent on which supply terminal provides the lower supply potential. The potential of the substrate therefore is at least almost equal to the lower supply potential.

The following discussion explains the invention in more details based on the following figures:
- Figure 1a: shows a MOS-transistor as an exemplary semiconductor component integrated in a semiconductor body, wherein parasitic thyristor-structures are illustrated by means of circuit diagrams symbols.
- Figure 1b: shows an equivalent circuit diagram for the circuit arrangement shown in figure 1a.
- Figure 2: shows the equivalent circuit diagram of an integrated circuit arrangement comprising a highside switch and a low-side switch.
- Figure 3: shows the integrated circuit arrangement of figure 2 including a parasitic thyristor-structure.
- Figure 4: shows a first embodiment of the invention comprising a circuit arrangement adapted for connecting at least one substrate terminal to either a first or to a second supply terminal dependent on which supply terminal provides the lower supply potential.
- Figure 5: shows another embodiment similar to the embodiment shown in figure 4, wherein the comparison of the supply potentials is provided by a first and a second transistor.

In the figures, unless otherwise indicated, the same reference notations refer to the same components or the same signals with the same meaning.

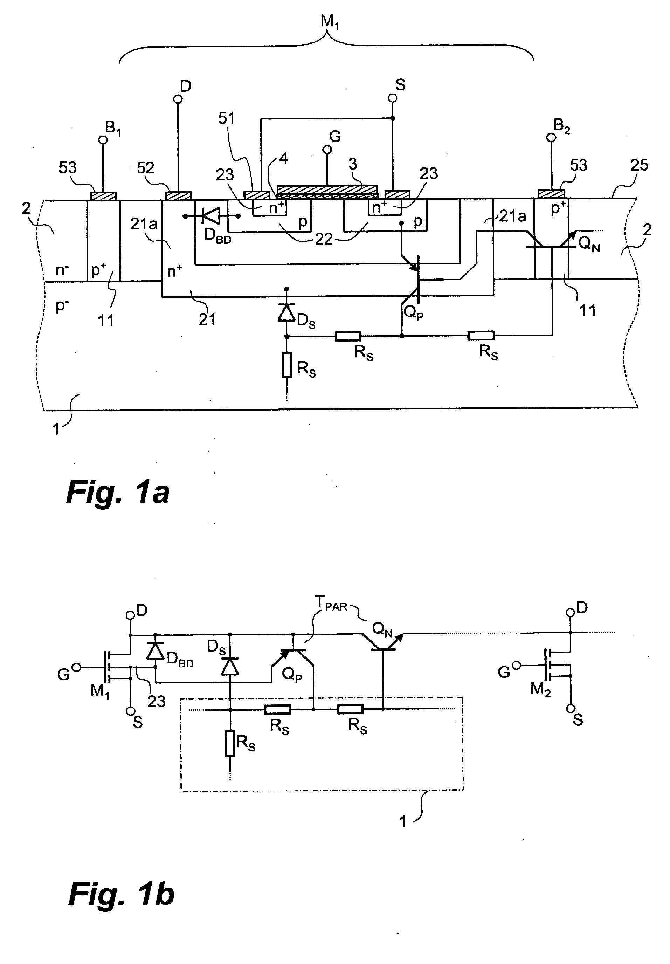

Figure 1a shows - as an exemplary semiconductor component - a MOS-transistor which is integrated in a semiconductor body. Parasitic diode and thyristor structures which are formed between active areas of the semiconductor component and between active areas and a semiconductor substrate are illustrated by means of circuit diagram symbols. The example shows an n-channel D-MOS transistor (double diffused vertical MOS transistor) disposed above an p-doped substrate. Of course the invention is also applicable to p-channel MOSFETs in n-doped substrate material and to pure bipolar technologies. Dependent on the manufacturing technology n-doped wafers can be used, too.

The embodiment depicted in figure 1a comprises a weakly p-doped substrate 1 with a weakly n-doped epitaxial layer 2 deposited thereon. A surface 25 of the epitaxial layer 2 forms a surface of the semiconductor body which is formed by the substrate 1 and the epitaxial layer 2. A semiconductor component M₁ is integrated into the semiconductor body (1, 2). In the present example the semiconductor body is an n-channel MOS transistor. Close to the boundary between the substrate 1 and the epitaxial layer 2 a heavily n-doped, buried drain zone 21 is located extending along the boundary in a lateral direction. The boundary may be overlapped by the drain zone 21, i.e. the buried drain zone 21 is partly located in the substrate 1 and partly located in the epitaxial layer 2. At least one drain contact zone 21a extends from the surface of the semiconductor body in a vertical direction to the drain zone 21 in order to allow a low-resistance external contacting of the drain zone 21. In the depicted embodiment one drain contact zone 21a is located on each side of the drain zone 21. At least one body zone 22 extends from the surface 25 of the semiconductor body into the epitaxial layer 2. In case of an n-channel MOSFET the body zone 22 is p-doped. In the depicted embodiment a second body zone 22 is located (in a lateral direction) adjacent to the aforementioned body zone 22. Surrounded by the body zones 22 an n-doped source zone 23 extends from the surface of the semiconductor body into each body zone 22. A gate electrode 3 extends parallel to the semiconductor surface 25 overlapping the body zone 22. The gate electrode 3 is isolated from the rest of the semiconductor body by an oxide layer 4. A metallization 51 covers at least partly the source zone 23 and the body zone 22, thus shortening source zone 23 and body zone 22 and providing an electrical contact to a source terminal S. A metallization 52 is disposed above the drain contact zone 21a by, thus providing an electric contact to a drain terminal D. A substrate contact zone 11 extends in a vertical direction from the surface 25 of the semiconductor body to the substrate 1. The substrate contact zone 11 encloses the semiconductor component M₁ and isolates the semiconductor component M₁ from other semiconductor components integrated in the same substrate 1. Pads of metallization 53 are used to provide an electric contact to substrate terminals B₁, B₂, etc. for contacting the substrate at different locations.

A pn-junction between the body zone 22 and the drain zone 21 (or the drain contact zone 21a) forms a so called body diode D_{BD}. The pn-junction between the drain zone 21 and the substrate 1 forms a substrate diode Dₛ. The body diode D_{BD} and the substrate diode together can also represented by a pnp-transistor Qp, wherein the body diode D_{BD} represents the emitter-base diode and the substrate diode Dₛ represents the collector-base diode of the pnp bipolar transistor Qp. That is, the p-doped body zone 22, the n-doped drain zone 21 and the p-doped substrate 1 form a (vertical) pnp-transistor Q_{P}. The n-doped drain zone 21, the p-doped substrate contact zone 11 and the epitaxial layer 2 "outside" the substrate contact zone 11 forms a (lateral) npn-transistor Q_{N}. The substrate is connected to the collector of the pnp-transistor Q_{P} and to the base of the npn-transistor Q_{N}. Resisters Rₛ indicate the non ideal conductivity of the substrate.

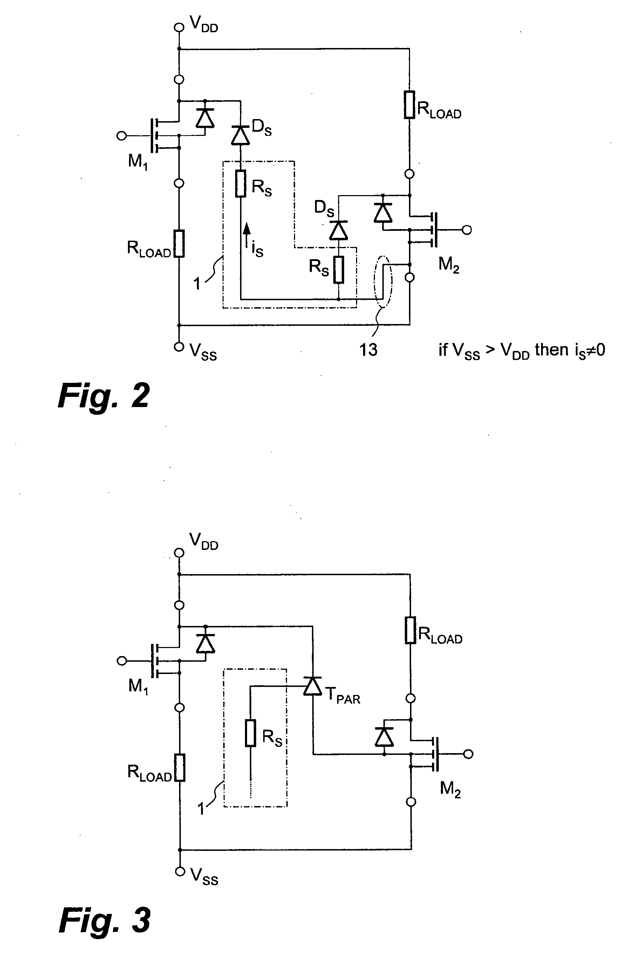

The electrical equivalent circuit of the semiconductor component described above is depicted in figure 1b and will be explained in more detail in the following. MOSFET M₁ is shown in the left part of the circuit diagram. The body diode D_{BD} connects the body 23 and the drain terminal D of the MOSFET M₁. The short circuits between the source and the body 23 (by means of metallization 51) are also shown in the circuit diagram. The drain of the MOSFET M₁ is connected to the base of the pnp-transistor Qp and to the collector of the npn-transisor Q_{N}. The body 23 is connected to the emitter of the pnp-tranistor Q_{P}. The base of the npn-transistor Q_{N} is connected to the collector of the pnp-transistor Qₚ via the substrate (indicated by means of the resistor Rₛ which symbolizes the resistivity of the substrate). The emitter of the npn-transistor Q_{N} can be connected to the drain of another MOSFET M₂ which can be integrated in the same semiconductor body (1, 2) adjacent to the MOS-transistor M₁. The substrate diode Dₛ connects the drain terminal of MOSFET M₁ and the substrate 1. The pnp-transistor Q_{P} and the npn-transistor Q_{N} together form a parasitic thyristor T_{PAR}, wherein the gate of the thyristor is formed by the substrate 1. The effect of this parasitic thyristor T_{PAR} is explained later in more detail with reference to figure 3.

Figure 2 shows a circuit arrangement comprising a first MOS-transistor M₁ serving as a high side semiconductor switch and a second MOS-transistor M₂ serving as a low side semiconductor switch. A drain terminal of the high side switch M₁ is connected to a first supply terminal providing a first supply potential V_{DD} and the source terminal of the high side switch M₁ is connected to a second supply terminal (providing a second supply potential Vₛₛ) via a resistive load R_{LOAD}. The low side switch M₂ has its source terminal directly connected to the second supply terminal (Vₛₛ) and its drain terminal connected to the first supply terminal V_{DD} via a load R_{LOAD}. For the further discussion it is assumed that the high side switch M₁ and the low side switch M₂ both are integrated in the same substrate 1 (cf. figure 1a). Consequently both transistors are coupled by the parasitic structures depicted in figures 1a and 1b. In the case shown in figure 2 only the substrate diodes Dₛ are relevant. The drain terminals of the high side and the low side switches M₁, M₂ are connected via their substrate diodes Dₛ and the substrate resistance Rₛ.

During normal operation the first supply potential V_{DD} is higher than the second supply potential Vₛₛ and the substrate is connected to the second supply potential Vₛₛ in order to inhibit the latch-up of the parasitic thyristor T_{PAR} formed by the bipolar transistors Q_{N} an Q_{P} (cf. figure 1b). Considering the case of a reverse voltage, i.e. the second supply potential Vₛₛ being higher than the first supply potential V_{DD}, one can easily see that the voltage source providing the supply potentials V_{DD} and Vₛₛ is shorted by the substrate diode Dₛ of the high side switch M₁ by providing a low-resistance current path from the second supply potential Vₛₛ to the first supply potential V_{DD}. As a consequence a high current Is flowing through the substrate diode of high side switch M₁ can destroy the high side switch M₁ and adjacent semiconductor components.

In order to prevent high substrate current in case of a reverse voltage the substrate may be isolated from the second supply potential Vₛₛ. As a consequence the potential of the substrate 1 is floating and determined by the state of adjacent semiconductor components integrated in the same semiconductor body. Having a floating substrate 1 the parasitic thyristor T_{PAR} connecting the drain of the high side switch M₁ and the body of the low side switch M₂ can not be neglected as already mentioned above. Figure 3 shows the high side switch M₁ and the low side switch M₂ of figure 2 additionally including the parasitic thyristor T_{PAR}, but neglecting the substrate diodes for the sake of simplicity. The gate of the parasitic thyristor T_{PAR} is connected to the substrate 1. It is obvious that a floating substrate 1 can easily activate the parasitic thyristor, thus again shortening the voltage source providing the supply potentials V_{DD} and Vₛₛ.

There is a need for an "intelligent" circuit for, on the one hand side, preventing a latch up of the parasitic thyristor T_{PAR} and, on the other hand side, preventing a short circuit via the substrate diodes Dₛ in reverse voltage operation as well as in normal operation.

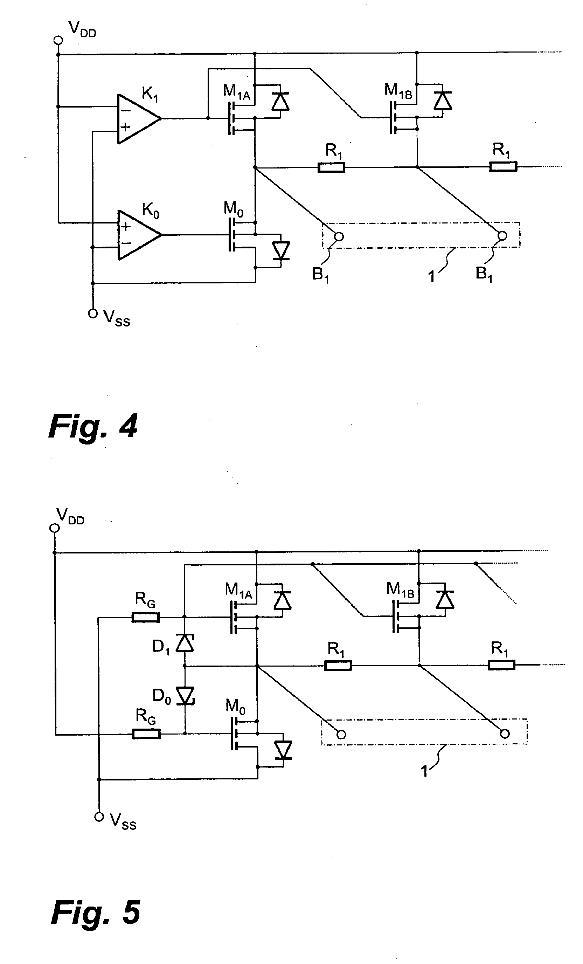

Figur 4 shows one exemplary embodiment of the inventive integrated circuit arrangement adapted for connecting the substrate terminals B₁, B₂, etc. with either the first or the second supply terminal dependent on which supply potential is the lowest. That is, the substrate terminals B₁, B₂ always receive the lowest supply potential which is the second supply potential Vₛₛ in normal operation and the first supply potential V_{DD} in reverse voltage operation.

Switching of the substrate potential is effected by means of a transistor half-bridge comprising a first semiconductor switch M_{1A} and a second semiconductor switch M₀, wherein the first semiconductor switch M_{1A} is connected between a first substrate terminal B₁ and the first supply terminal (V_{DD}) and wherein the second semiconductor switch M₀ is connected between the first substrate terminal B₁ and the second supply terminal (Vₛₛ). That is, the common node of the semiconductor switches M_{1A} and M₀ is connected to one substrate terminal (e. g. substrate terminal B₁) and the switching state of the half-bridge determines the potential of the substrate 1. A first and a second comparator K₁, K₀ control the switching states of the first and the second semiconductor switch M_{1A}, M₀ of the half-bridge such, that the first semiconductor switch M_{1A} in an on-state and the second semiconductor switch M₀ is in an off-state if the first supply potential V_{DD} is lower than the second supply potential Vₛₛ (i. e. reverse voltage operation), and vice versa. An output terminal of the first comparator K₁ is therefore connected to a control terminal of the first semiconductor switch M_{1A}, and an output of the second comparator K₀ is connected to a control terminal of the second semiconductor switch M₀. Both comparators K₁, K₀ have an inverting and a non-inverting input, wherein the inverting input of the first comparator K₁ and the non-inverting input of the second comparator K₀ are connected to the first supply terminal (V_{DD}), and the non-inverting input of the first comparator K₁ and the inverting input of the second comparator K₀ are connected to the second supply terminal V_{SS}.

Optionally a further semiconductor switch M_{1B} is connected between the first supply terminal (V_{DD}) and a second substrate terminal B₂, wherein a control terminal of the further semiconductor switch M_{1B} is connected to the control terminal of the first semiconductor switch M_{1A}. This further semiconductor switch M_{1B} allows to contact different substrate terminals (B₁, B₂, etc.) in order to provide a uniform electric substrate potential (V_{DD}) to the substrate 1 in case of a reverse voltage operation. During normal operation it can be useful to connect only one substrate terminal B₁ to the second supply potential Vₛₛ and to connect further substrate terminals (B₂, etc.) to the second supply potential Vₛₛ via a parallel resistor R1 (parallel to the substrate resistance Rₛ). This is espeacially expedient, if a "hard" connection to Vₛₛ is unwanted to allow special guard rings to operate properly inhibiting adverse effects of a reverse current.

If - during normal operation - a reverse current flows from the source to the drain terminal, of transistor M₂, for example, then transistor Q_{N} can be activated and will inject minority carriers into the substrate leading to possible malfunction of other parts of the circuit integrated in the same substrate. Several techniques may be applied to reduce the activation of npn transistor Q_{N}. Most of them are based on guard ring arrangements that are shorting by a means of a switch the base-emitter junction of npn transistor Q_{N} during reverse current operation. To be effective, the substrate resistance close to the npn transistor Q_{N} has to be high, allowing to the substrate potential to be pulled to the lowest possible potential, which is the voltage drop Vₛₛ - V_{BD} across body diode D_{BD} during reverse current operation. Therefore some substrate terminals (e.g. B₂) are not directly switched to the second supply potential Vₛₛ but via a resistor R₁. That is, the function of resistor R₁ is to decouple two or more substrate locations on the same chip. While substrate terminal B₁ is connected via the low-resistance semiconductor switch M₀ to V_{SS}, the further substrate terminal B₂ is connected via a higher resistance, given by the parallel connection of R₁ with the substrate resistance.

One simple embodiment of the invention is depicted in figure 5. The semiconductor switches (M_{1A}, M_{1B}, etc., and M₀) are usually implemented as MOS-transistors having a drain terminal, a source terminal, and a gate terminal (control terminal). The drain terminal of the first semiconductor switch M_{1A} is connected to the first supply terminal (V_{DD}), the drain terminal of the second semiconductor switch M₀ is connected to the second supply terminal (Vₛₛ). The gate terminal of the first semiconductor switch M_{1A} is connected to the second supply terminal (Vₛₛ) via a first gate resistor R_{G}, the gate terminal of the second semiconductor switch M₀ is connected to the first supply terminal via a second gate resistor R_{G}. The source terminals of the first and the second semiconductor switch M_{1A}, M₀ both are connected to a first substrate terminal B1. Optionally at least one further semiconductor switch M_{1B} is connected between the first supply terminal (V_{DD}) and a second substrate terminal. The drain terminal of each further semiconductor switch M_{1B} is connected to the drain terminal of the first semiconductor switch M_{1A} (and therefore to the first supply terminal), the gate terminal of each further semiconductor switch M_{1B} is connected to the gate terminal of the first semiconductor switch M_{1A}, and each source terminal of the further semiconductor switches is connected to a different substrate terminal (B₂, etc.) for the reasons explained above.

## Claims

1. An integrated circuit arrangement comprising
a semiconductor body (1, 2) having a substrate (1) and at least one substrate terminal (B₁, B₂),
at least one semiconductor component (M₁, M₂) integrated in said semiconductor body (1, 2) and being connected between a first supply terminal providing a first supply potential (V_{DD}) and a second supply terminal providing a second supply potential (Vₛs), and
switching means adapted for connecting at least one of said substrate terminals (B₁, B₂) to either said first or to said second supply terminal (V_{DD}, Vₛₛ) dependent on which supply terminal provides the lower supply potential.

2. The integrated circuit arrangement of claim 1, wherein said switching means comprises a first semiconductor switch (M_{1A}) and a second semiconductor switch (M₀), wherein said first semiconductor switch (M_{1A}) is connected between a first substrate terminal (B₁) and said first supply terminal (V_{DD}) and wherein second first semiconductor switch (M₀) is connected between said first substrate terminal (B₁) and said second supply terminal (Vₛₛ).

3. The integrated circuit arrangement of claim 2, wherein said switching means further comprise a first and a second comparator (K₁, K₀) controlling the switching states of said first and said second semiconductor switch (M_{1A}, M₀) such, that said first semiconductor switch (M_{1A}) is in an on-state and said second semiconductor switch (M₀) is in an off-state, if said first supply potential (V_{DD}) is lower than said second supply potential (Vₛₛ), and vice versa.

4. The integrated circuit arrangement of claim 2,wherein said first and said second semiconductor switch (M_{1A}, M₀) are MOS-transistors each having a drain-terminal, a source-terminal, and a gate-terminal, wherein
said drain-terminal of said first semiconductor switch (M_{1A}) is connected to said first supply terminal (V_{DD}),
said drain-terminal of said second semiconductor switch (M₀) is connected to said second supply terminal (V_{SS}),
said gate-terminal of said first semiconductor switch (M_{1A}) is connected to said second supply terminal (Vₛₛ) via a first gate resistor (R_{G}),
said gate-terminal of said second semiconductor switch (M₀) is connected to said first supply terminal (V_{DD}) via a second gate resistor (R_{G}), and
said source-terminals of said first and said second semiconductor switch (M_{1A}, M₀) both are connected to said first substrate terminal (B₁).

5. The integrated semiconductor arrangement of claims 2 to 4 wherein said switching means further comprise at least one further semiconductor switch (M_{1B}) each having a drain-terminal, a source-terminal, and a gate-terminal, wherein
said drain-terminals of said further semiconductor switches (M_{1B}) are connected to said drain-terminal of said first semiconductor switch (M_{1A}),
said gate-terminals of said further semiconductor switches (M_{1B}) are connected to said gate-terminal of said first semiconductor switch (M_{1A}), and
said source-terminals of said further semiconductor switches (M_{1B}) each are connected to different substrate-terminals (B₁, B₂).

6. The integrated semiconductor arrangement of claim 5, wherein said different substrate-terminals (B₁, B₂) are connected via parallel resistors (R₁).

## Amended claims

### Amended claims in accordance with Rule 137(2) EPC.

**1.** An integrated circuit arrangement with a reverse voltage protection, the circuit arrangement comprising:
a semiconductor body (1, 2) having a substrate (1) and at least one substrate terminal (B₁, B₂);
at least one semiconductor component (M₁, M₂) integrated in said semiconductor body (1, 2) and being connected between a first supply terminal providing a first supply potential and a second supply terminal providing a second supply potential (V_{SS}), said first supply potential (V_{DD}) being higher than said second supply potential (V_{SS}) during normal operation of said semiconductor component (M₁, M₂) and said first supply potential (V_{DD}) being lower than said second supply potential (V_{SS}) during reverse voltage operation of said semiconductor component (M₁, M₂); and
switching means adapted for connecting at least one of said substrate terminals (B₁, B₂) to said first supply terminal (V_{DD}) during reverse voltage operation and to said second supply terminal (V_{SS}) during normal operation.

**2.** The integrated circuit arrangement of claim 1, wherein said switching means is adapted for connecting different substrate terminals (B₁, B₂) to said first supply terminal (V_{DD}) during reverse voltage operation, thus providing a uniform substrate potential in case of a reverse voltage operation.

**3.** The integrated circuit arrangement of claim 1 or 2, wherein said switching means comprises a first semiconductor switch (M_{1A}) and a second semiconductor switch (M₀), wherein said first semiconductor switch (M_{1A}) is connected between a first substrate terminal (B₁) and said first supply terminal (V_{DD}) and wherein second first semiconductor switch (M₀) is connected between said first substrate terminal (B₁) and said second supply terminal (V_{SS}).

**4.** The integrated circuit arrangement of claim 3, wherein said switching means further comprise a first and a second comparator (K₁, K₀) controlling the switching states of said first and said second semiconductor switch (M_{1A}, M₀) such, that said first semiconductor switch (M_{1A}) is in an on-state and said second semiconductor switch (M₀) is in an off-state during reverse voltage operation, and vice versa during normal operation of said semiconductor component.

**5.** The integrated circuit arrangement of claim 3,wherein said first and said second semiconductor switch (M_{1A}, M₀) are MOS-transistors each having a drain-terminal, a source-terminal, and a gate-terminal, wherein
said drain-terminal of said first semiconductor switch (M_{1A}) is connected to said first supply terminal (V_{DD}),
said drain-terminal of said second semiconductor switch (M₀) is connected to said second supply terminal (V_{SS}),
said gate-terminal of said first semiconductor switch (M_{1A}) is connected to said second supply terminal (V_{SS}) via a first gate resistor (R_{G}),
said gate-terminal of said second semiconductor switch (M₀) is connected to said first supply terminal (V_{DD}) via a second gate resistor (R_{G}), and
said source-terminals of said first and said second semiconductor switch (M_{1A}, M₀) both are connected to said first substrate terminal (B₁).

**6.** The integrated semiconductor arrangement of one of claims 3 to 5, wherein said switching means further comprise at least one further semiconductor switch (M_{1B}) each having a drain-terminal, a source-terminal, and a gate-terminal, wherein
said drain-terminals of said further semiconductor switches (M_{1B}) are connected to said drain-terminal of said first semiconductor switch (M_{1A}),
said gate-terminals of said further semiconductor switches (M_{1B}) are connected to said gate-terminal of said first semiconductor switch (M_{1A}), and
said source-terminals of said further semiconductor switches (M_{1B}) each are connected to different substrate-terminals (B₁, B₂).

**7.** The integrated semiconductor arrangement of claim 6, wherein said different substrate-terminals (B₁, B₂) are connected via parallel resistors (R₁).
